(19) Europäisches Patentamt European Patent Office Office européen des brevets

(11) **EP 4 782 849 A1**

(12) **EUROPEAN PATENT APPLICATION**
published in accordance with Art. 153(4) EPC

(43) Date of publication:
29.07.2026 Bulletin 2026/31

(21) Application number: 24866804.8

(22) Date of filing: 26.03.2024

(51) International Patent Classification (IPC):
*G01R 27/26* (2006.01)

(86) International application number:
PCT/CN2024/083702

(87) International publication number:
WO 2025/060378 (27.03.2025 Gazette 2025/13)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 18.09.2023 CN 202311206614

(71) Applicant: Sungrow Power Supply Co., Ltd.
Hefei, Anhui 230088 (CN)

(72) Inventors:
• **DENG, Kai**
**Hefei, Anhui 230088 (CN)**
• **LIAN, Chao**
**Hefei, Anhui 230088 (CN)**

(74) Representative: **Epping - Hermann - Fischer Patentanwaltsgesellschaft mbH**
**Schloßschmidstraße 5**
**80639 München (DE)**

(54) **CAPACITANCE VALUE MEASUREMENT METHOD FOR DIRECT-CURRENT BUS CAPACITOR AND ELECTRIC ENERGY CONVERSION APPARATUS**

(57) A capacitance value measurement method for a direct-current bus capacitor and an electric energy conversion apparatus. The method comprises: when a power supply is connected to a direct-current side of an electric energy conversion apparatus, acquiring the actual charging/discharging time of a direct-current bus capacitor of the electric energy conversion apparatus (101); when the actual charging/discharging time is the actual charging time, the voltage of the fully charged direct-current bus capacitor being smaller than the voltage of the power supply; comparing the actual char- ging/discharging time with a corresponding preset charging/discharging time to obtain a comparison result (102); and, according to the comparison result, determining whether the capacitance value of the direct current bus capacitor has been attenuated (103). The method does not need to specifically calculate capacitance values of direct-current bus capacitors so as to allow for a small amount of calculation, reducing pressure on corresponding processors and limitations on selecting the processors.

```
┌─────────────────────────────────────────────────────────┐
│ Obtain an actual charging-discharging duration of a     │ ─── 101
│ direct-current bus capacitor of a power conversion       │
│ apparatus, where the actual charging-discharging         │
│ duration starts from a time instant when a direct-       │
│ current side of the power conversion apparatus is        │
│ connected to a power supply                              │
└─────────────────────────────────────────────────────────┘
                          │
                          ▼
┌─────────────────────────────────────────────────────────┐
│ Compare the actual charging-discharging duration with a │ ─── 102
│ preset charging-discharging duration to obtain a         │
│ comparison result                                        │
└─────────────────────────────────────────────────────────┘
                          │
                          ▼
┌─────────────────────────────────────────────────────────┐
│ Determine, based on the comparison result, whether a    │ ─── 103
│ capacitance of the direct-current bus capacitor degrades │
└─────────────────────────────────────────────────────────┘
```

**FIG. 1**

EP 4 782 849 A1

## Description

This application claims the priority to Chinese Patent Application No. CN202311206614.0, titled "CAPACITANCE VALUE MEASUREMENT METHOD FOR DIRECT-CURRENT BUS CAPACITOR AND ELECTRIC ENERGY CONVERSION APPARATUS", filed on September 18, 2023 with the China National Intellectual Property Administration, which is incorporated herein by reference in its entirety.

## FIELD

The present disclosure relates to the technical field of capacitance detection, and in particular to a method for detecting a capacitance of a direct-current bus capacitor, and a power conversion apparatus.

## BACKGROUND

Direct-current bus capacitors include large-capacity film capacitors and electrolytic capacitors. Due to the fact that the direct-current bus capacitor often operates in a high-temperature and high-humidity environment, a capacitance of the direct-current bus capacitor is prone to degradation. The degradation of the capacitance of the direct-current bus capacitor may affect normal operation of a corresponding device. Therefore, it is required to detect the capacitance of the direct-current bus capacitor to identify a degraded direct-current bus capacitor based on a detection result.

Currently, a voltage, a current, and a frequency thereof of the direct-current bus capacitor are obtained through a voltage detection circuit and a current detection circuit, and then the capacitance of the direct-current bus capacitor is calculated based on the frequency. However, due to the present of multiple frequency bands in an actual current waveform, the computational process of the above solution is relatively complex, increasing processing load on a processor and imposing limitations on the selection of the processor.

## SUMMARY

To address the issues in the related art that a relatively complex computation increases processing load on a processor and imposes limitations on the selection of the processor, a method for detecting a capacitance of a direct-current bus capacitor, and a power conversion apparatus are provided according to the present disclosure.

The technical solutions of the present disclosure are as follows.

A method for detecting a capacitance of a direct-current bus capacitor is provided according to the present disclosure. The method includes:

obtaining an actual charging-discharging duration of the direct-current bus capacitor of a power conversion apparatus, where the actual charging-discharging duration starts from a time instant when a direct-current side of the power conversion apparatus is connected to a power supply, and a voltage of the direct-current bus capacitor upon completion of charging the direct-current bus capacitor is less than a voltage of the power supply in response to the actual charging-discharging duration being an actual charging duration;

comparing the actual charging-discharging duration with a preset charging-discharging duration to obtain a comparison result; and

determining, based on the comparison result, whether the capacitance of the direct-current bus capacitor degrades.

In an embodiment, the comparison result is a ratio of the actual charging-discharging duration to the preset charging-discharging duration.
where the determining, based on the comparison result, whether the capacitance of the direct-current bus capacitor degrades includes determining whether the ratio is less than a preset ratio threshold; and determining, in response to the ratio being less than the preset ratio threshold, that the capacitance of the direct-current bus capacitor degrades.

In an embodiment, the obtaining the actual charging-discharging duration of the direct-current bus capacitor of the power conversion apparatus includes:

obtaining an actual charging duration of the direct-current bus capacitor in response to the direct-current bus capacitor being in a charging state, where the charging state refers to a charging state during an initial soft start within a preset cycle; or
obtaining an actual discharging duration of the direct-current bus capacitor in response to the direct-current bus capacitor being in a discharging state.

In an embodiment, before comparing the actual charging-discharging duration with the preset charging-discharging duration, the method further includes:
calculating the preset charging-discharging duration.

In an embodiment, the calculating the preset charging-discharging duration includes:
calculating the preset charging-discharging duration based on an initial voltage and a target voltage of the direct-current bus capacitor, the voltage of the power supply, an initial capacitance of the direct-current bus capacitor, and a resistance of a charging-discharging branch.

In an embodiment, in response to the actual charging-discharging duration being an actual charging duration of the direct-current bus capacitor in a charging state during an initial soft start within a preset cycle, the initial voltage is zero, and the resistance of the charging-discharging branch is a resistance of a soft start resistor between the power supply and the direct-current bus capacitor.

In an embodiment, the target voltage is equal to a difference between the voltage of the power supply and a preset voltage.

In an embodiment, after determining, based on the comparison result, whether the capacitance of the direct-current bus capacitor degrades, the method further includes:

controlling, in response to determining that the capacitance of the direct-current bus capacitor degrades, a device in which the direct-current bus capacitor is located to be shut down.

A power conversion apparatus is provided according to the present disclosure. The power conversion apparatus includes a main circuit and a controller.

In the main circuit, a direct-current bus capacitor is connected between a positive electrode and a negative electrode of a direct-current bus.

The controller is configured to detect a capacitance of the direct-current bus capacitor by using the method described above.

In an embodiment, the main circuit includes a soft start unit and a power conversion circuit.

A direct-current side of the power conversion circuit is connected to the direct-current bus.

The soft start unit is connected in parallel with a main contactor between the direct-current bus and a power supply.

In an embodiment, the soft start unit includes a soft start contactor and a soft start resistor.

The soft start contactor is connected in series with the soft start resistor.

The above technical solutions of the present disclosure have the following beneficial effects.

An actual charging-discharging duration of the direct-current bus capacitor of a power conversion apparatus is obtained, where the actual charging-discharging duration starts from a time instant when a direct-current side of the power conversion apparatus is connected to a power supply; the actual charging-discharging duration of the direct-current bus capacitor is compared with a preset charging-discharging duration; and whether the capacitance of the direct-current bus capacitor degrades is determined based on a comparison result. With the method, the capacitance of the direct-current bus capacitor is not calculated, achieving a relatively small computational load, thereby reducing the processing load on the processor and lowering the limitations on the selection of the processor in the present disclosure.

## BRIEF DESCRIPTION OF THE DRAWINGS

In order to more clearly illustrate the technical solutions in the embodiments of the present disclosure or in the conventional technology, the drawings used in the description of the embodiments or the conventional technology will be briefly described hereinafter. It is apparent that the drawings in the following description are only some of the embodiments of the present disclosure, and based on these drawings, other drawings may be obtained by those skilled in the art without creative efforts.

FIG. 1 is a schematic flowchart of a method for detecting a capacitance of a direct-current bus capacitor according to an embodiment of the present disclosure;

FIG. 2 is a schematic flowchart of a method for detecting a capacitance of a direct-current bus capacitor according to another embodiment of the present disclosure; and

FIG. 3 is a schematic structural diagram of a power conversion apparatus according to an embodiment of the present disclosure.

## DETAILED DESCRIPTION

The technical solutions according to the embodiments of the present disclosure will be described clearly and completely as follows in conjunction with the drawings in the embodiments of the present disclosure. It is apparent that the described embodiments are only some of the embodiments according to the present disclosure, rather than all the embodiments. All other embodiments obtained by those skilled in the art based on the embodiments of the present disclosure without any creative work fall within the protection scope of the present disclosure.

Direct-current bus capacitors include large-capacity film capacitors and electrolytic capacitors. In a power conversion apparatus adopting a pulse width modulation (PWM) control algorithm, a direct-current bus capacitor absorbs a ripple current at a corresponding frequency. For example, in a power conversion apparatus adopting an SVPWM control algorithm, the direct-current bus capacitor absorbs a triple-frequency ripple current and a switching-frequency ripple.

However, due to the fact that the direct-current bus capacitor often operates in a high-temperature and high-humidity environment, a capacitance of the direct-current bus capacitor is prone to degradation. The degradation of the capacitance of the direct-current bus capacitor results in an increase of the ripple current. If the ripple current remains high over a long time period, thermal runaway may occur in the power conversion apparatus, affecting normal operation of the power conversion apparatus. Therefore, it is required to detect the capacitance of the direct-current bus capacitor. Once the capacitance degradation of the direct-current bus capacitor is detected, the direct-current bus capacitor is replaced or an additional direct-current bus capacitor is arranged promptly.

Currently, a voltage, a current, and a frequency thereof of the direct-current bus capacitor are obtained through a voltage detection circuit and a current detection circuit, and then the capacitance of the direct-current bus capacitor is calculated based on the frequency. However, due to the present of multiple frequency bands in an actual current waveform, the computational process of the above solution is relatively complex, increasing processing load on a processor and imposing limitations on the selection of the processor.

To reduce the computational load in the process of detecting the capacitance of the direct-current bus capacitor, and to reduce the processing load on the processor and lower the limitations on the selection of the processor, a method for detecting a capacitance of a direct-current bus capacitor, and a power conversion apparatus are provided according to the present disclosure.

The technical solutions of the present disclosure are described in detail below in conjunction with the drawings.

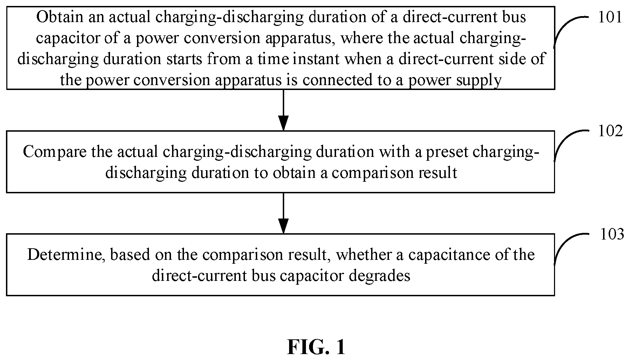

FIG. 1 is a schematic flowchart of a method for detecting a capacitance of a direct-current bus capacitor according to an embodiment of the present disclosure. As shown in FIG. 1, the method includes the following steps 101 to 103.

In step 101, an actual charging-discharging duration of the direct-current bus capacitor of a power conversion apparatus is obtained, where the actual charging-discharging duration starts from a time instant when a direct-current side of the power conversion apparatus is connected to a power supply, and a voltage of the direct-current bus capacitor upon completion of charging the direct-current bus capacitor is less than a voltage of the power supply in response to the actual charging-discharging duration being an actual charging duration.

In an embodiment of the present disclosure, the actual charging-discharging duration is an actual charging duration or an actual discharging duration. The actual charging duration of the direct-current bus capacitor may be a duration actually taken for a voltage of the direct-current bus capacitor in a charging state to rise from a first voltage to a second voltage. The actual discharging duration of the direct-current bus capacitor may be a duration actually taken for the voltage of the direct-current bus capacitor in a discharging state to drop from a third voltage to a fourth voltage.

In practical applications, during a process of charging the direct-current bus capacitor, a charging speed slows down when the voltage of the direct-current bus capacitor approaches the voltage of the power supply. Therefore, provided that the relevant contactor is capable of withstanding current surge when closing, the voltage of the direct-current bus capacitor upon completion of charging the direct-current bus capacitor is set to be less than the voltage of the power supply. In this way, a charging duration of the direct-current bus capacitor can be shortened, so that the actual charging duration of the direct-current bus capacitor can be quickly acquired, thereby improving the efficiency of detecting the capacitance of the direct-current bus capacitor.

In step 102, the actual charging-discharging duration is compared with a preset charging-discharging duration to obtain a comparison result.

In an embodiment of the present disclosure, if an actual charging duration of the direct-current bus capacitor is obtained in step 101, the actual charging duration of the direct-current bus capacitor is compared with a theoretical charging duration in step 102. If an actual discharging duration of the direct-current bus capacitor is obtained in step 101, the actual discharging duration of the direct-current bus capacitor is compared with a theoretical discharging duration in step 102.

The theoretical charging duration corresponding to the actual charging duration refers to a duration theoretically taken for the voltage of the direct-current bus capacitor with an initial capacitance in the charging state to rise from the first voltage to the second voltage. The theoretical discharging duration corresponding to the actual discharging duration refers to a duration theoretically taken for the voltage of the direct-current bus capacitor with the initial capacitance in the discharging state to drop from the third voltage to the fourth voltage.

In step 103, whether the capacitance of the direct-current bus capacitor degrades is determined based on the comparison result.

According to the above technical solutions of the embodiments of the present disclosure, an actual charging-discharging duration of the direct-current bus capacitor of a power conversion apparatus is obtained, and the actual charging-discharging duration starts from a time instant when a direct-current side of the power conversion apparatus is connected to a power supply; the actual charging-discharging duration of the direct-current bus capacitor is compared with a preset charging-discharging duration; and whether the capacitance of the direct-current bus capacitor degrades is determined based on a comparison result. With the method, the capacitance of the direct-current bus capacitor is not calculated, achieving a relatively small computational load, thereby reducing the processing load on the processor and lowering the limitations on the selection of the processor in the present disclosure.

In an embodiment of the present disclosure, the comparison result is a ratio of the actual charging-discharging duration to the preset charging-discharging duration.

The determining, based on the comparison result, whether the capacitance of the direct-current bus capacitor degrades in step 103 includes:

> determining whether the ratio of the actual charging-discharging duration to the preset charging-discharging duration is less than a preset ratio threshold; and

determining, in response to the ratio of the actual charging-discharging duration to the preset charging-discharging duration being less than the preset ratio threshold, that the capacitance of the direct-current bus capacitor degrades.

In practical applications, the capacitance of the direct-current bus capacitor often fluctuates within a predetermined range, for example, 10%. In the embodiment of the present disclosure, the preset ratio threshold is determined based on the fluctuation range of the capacitance of the direct-current bus capacitor. For example, the preset ratio threshold may be directly determined based on the fluctuation range of the capacitance of the direct-current bus capacitor, that is, the preset ratio threshold may be 0.9. In this way, the accuracy of detecting the capacitance of the direct-current bus capacitor is improved.

Furthermore, the comparison result may be an absolute value of a difference between the actual charging-discharging duration and the preset charging-discharging duration. In this case, the determining, based on the comparison result, whether the capacitance of the direct-current bus capacitor degrades in step 103 further includes:

determining whether the absolute value of the difference between the actual charging-discharging duration and the preset charging-discharging duration is greater than a preset difference threshold; and

determining, in response to the absolute value of the difference between the actual charging-discharging duration and the preset charging-discharging duration being greater than the preset difference threshold, that the capacitance of the direct-current bus capacitor degrades.

The value of the preset difference threshold may be determined based on the fluctuation range of the capacitance of the direct-current bus capacitor, which is not limited herein, depending on the application environment.

In an embodiment of the present disclosure, the obtaining the actual charging-discharging duration of the direct-current bus capacitor of the power conversion apparatus in step 101 includes:

obtaining the actual charging duration of the direct-current bus capacitor in response to the direct-current bus capacitor being in a charging state; or

obtaining an actual discharging duration of the direct-current bus capacitor in response to the direct-current bus capacitor being in a discharging state.

In an embodiment of the present disclosure, whether the capacitance of the direct-current bus capacitor degrades is determined by comparing the actual charging duration of the direct-current bus capacitor with the theoretical charging duration. In this case, the obtaining the actual charging-discharging duration of the direct-current bus capacitor of the power conversion apparatus in step 101 may include obtaining the actual charging duration of the direct-current bus capacitor in response to the direct-current bus capacitor being in the charging state.

Alternatively, whether the capacitance of the direct-current bus capacitor degrades is determined by comparing the actual discharging duration of the direct-current bus capacitor with the theoretical discharging duration. In this case, the obtaining the actual charging-discharging duration of the direct-current bus capacitor of the power conversion apparatus in step 101 further includes obtaining the actual discharging duration of the direct-current bus capacitor in response to the direct-current bus capacitor being in the discharging state.

In an embodiment of the present disclosure, the obtaining the actual charging duration of the direct-current bus capacitor includes:
determining a duration between a start time instant and an end time instant of a soft start of the direct-current bus capacitor as the actual charging duration.

In an embodiment of the present disclosure, before the determining the duration between the start time instant and the end time instant of the soft start of the direct-current bus capacitor, the method in the embodiments of the present disclosure further includes:

determining a current time instant upon issuing a soft start instruction as the start time instant; and

determining a current time instant upon the voltage of the direct-current bus capacitor reaching a target voltage as the end time instant.

In an embodiment of the present disclosure, during the soft start of the direct-current bus capacitor, the soft start ends when the voltage of the direct-current bus capacitor rises to a preset voltage, that is, the target voltage.

Here, the target voltage may be equal to a difference between the voltage of the power supply connected to the direct-current bus capacitor and a preset voltage. As mentioned earlier, during the process of charging the direct-current bus capacitor, the charging speed slows down when the voltage of the direct-current bus capacitor approaches the voltage of the power supply connected to the direct-current bus capacitor. Therefore, provided that the relevant contactor is capable of withstanding current surge when closing, the preset voltage should be relatively large, to maximize a difference between the target voltage and the voltage of the power supply connected to the direct-current bus capacitor. In an example, the preset voltage is set to 30V.

Furthermore, in the above technical solution, since the difference between the target voltage and the voltage of the power supply connected to the direct-current bus capacitor is determined, only one of the target voltage and the voltage of the power supply may be detected and the other may be calculated based on the difference. Alternatively, the two voltages may be detected, and the difference may be used to verify the voltage detection result.

In an embodiment of the present disclosure, the charging state of the direct-current bus capacitor may refer to a charging state each time the direct-current bus capacitor performs a soft start, or may refer to a charging state during an initial soft start of the direct-current bus capacitor within a preset cycle.

In an embodiment of the present disclosure, when the power conversion apparatus is initially powered on, the voltage of the direct-current bus capacitor is generally 0. When the capacitance of the direct-current bus capacitor with an initial voltage of 0 is detected during the initial soft start, whether the capacitance of the direct-current bus capacitor degrades may be determined by comparing the duration actually taken for the direct-current bus capacitor to perform the initial soft start with the duration theoretically taken for the direct-current bus capacitor to perform the initial soft start. In this case, the charging state of the direct-current bus capacitor may be the charging state during the initial soft start of the direct-current bus capacitor. Based on this, since the initial voltage of the direct-current bus capacitor during the initial soft start is determined as 0, it is not required to detect the initial voltage of the direct-current bus capacitor in this solution, which is conducive to improving the efficiency of detecting the capacitance of the direct-current bus capacitor.

Moreover, in order to promptly identify a direct-current bus capacitor with a degraded capacitance, the capacitance of the direct-current bus capacitor may be periodically detected. That is, the preset cycle may be determined according to actual conditions. In an example, each day when the power conversion apparatus is initially powered on, a process of determining whether the capacitance of the direct-current bus capacitor degrades is performed by using the duration actually taken for the direct-current bus capacitor to perform the initial soft start and the duration theoretically taken for the direct-current bus capacitor to perform the initial soft start. Additionally, the preset cycle may be two days, one week, or the like, and can be determined according to actual requirements by those skilled in the art.

In an embodiment of the present disclosure, before comparing the actual charging-discharging duration with the preset charging-discharging duration, the method further includes calculating the preset charging-discharging duration.

In an embodiment of the present disclosure, the calculating the preset charging-discharging duration includes calculating the preset charging-discharging duration based on an initial voltage and a target voltage of the direct-current bus capacitor, the voltage of the power supply connected to the direct-current bus capacitor, an initial capacitance of the direct-current bus capacitor, and a resistance of a charging-discharging branch.

In an embodiment of the present disclosure, in response to the actual charging-discharging duration being an actual charging duration of the direct-current bus capacitor in a charging state during an initial soft start within a preset cycle, the initial voltage is zero, and the resistance of the charging-discharging branch is a resistance of a soft start resistor between the power supply and the direct-current bus capacitor. Since the soft start resistor has a low number of operating cycles and a high precision, the resistance of the soft start resistor may be regarded to be constant.

In an embodiment of the present disclosure, methods for calculating the theoretical charging duration and the theoretical discharging duration are described in related art. The following uses a method for calculating the theoretical charging duration as an example for explanation.

In an embodiment of the present disclosure, when the direct-current bus capacitor is in the charging state, a voltage $V_t$ of the direct-current bus capacitor at a time instant t is expressed as:

$$V_t = V_O + (V_{bat} - V_0)(1 - e^{-t/RC}) \qquad (1)$$

where Vo represents the initial voltage of the direct-current bus capacitor; $V_{bat}$ represents the voltage of the power supply connected to the direct-current bus capacitor; R represents the resistance of the charging-discharging branch of the direct-current bus capacitor; and C represents the initial capacitance of the direct-current bus capacitor.

The theoretical charging duration is a duration for $V_t$ to rise to the target voltage. When the power conversion apparatus is a power conversion system (PCS), $V_{bat}$ represents a voltage of a battery connected to the direct-current bus capacitor.

When $V_O$ is 0, the theoretical charging duration $t_1$ is expressed as:

$$t_1 = RC \ln(V_{bat}/V_{bat} - V_t) \qquad (2)$$

where Vt represents the target voltage. Following the above example, $V_t = V_{bat} - 30$ is obtained.

When $V_O$ is not 0, the theoretical charging duration $t_1$ may be calculated according to equation (1) by those skilled in the art.

In an embodiment of the present disclosure, after determining, based on the comparison result, whether the capacitance of the direct-current bus capacitor degrades in step 103, the method further includes: controlling, upon determining that the capacitance of the direct-current bus capacitor degrades, a device in which the direct-current bus capacitor is located to be shut down.

After the device in which the direct-current bus capacitor is located is shut down, the direct-current bus capacitor with the degraded capacitance may be replaced by relevant personnel.

The above technical solution is comprehensively explained hereinafter by taking the charging process of the direct-current bus capacitor as an example. In this embodiment, whether the capacitance of the direct-current bus capacitor degrades is determined by comparing the duration actually taken for the direct-current bus capacitor to perform the initial soft start with the duration theoretically required for the direct-current bus capacitor to perform the initial soft start.

It should be noted that the method for detecting the capacitance of the direct-current bus capacitor during the discharging process follows the same principle as the charging process and is not repeated herein.

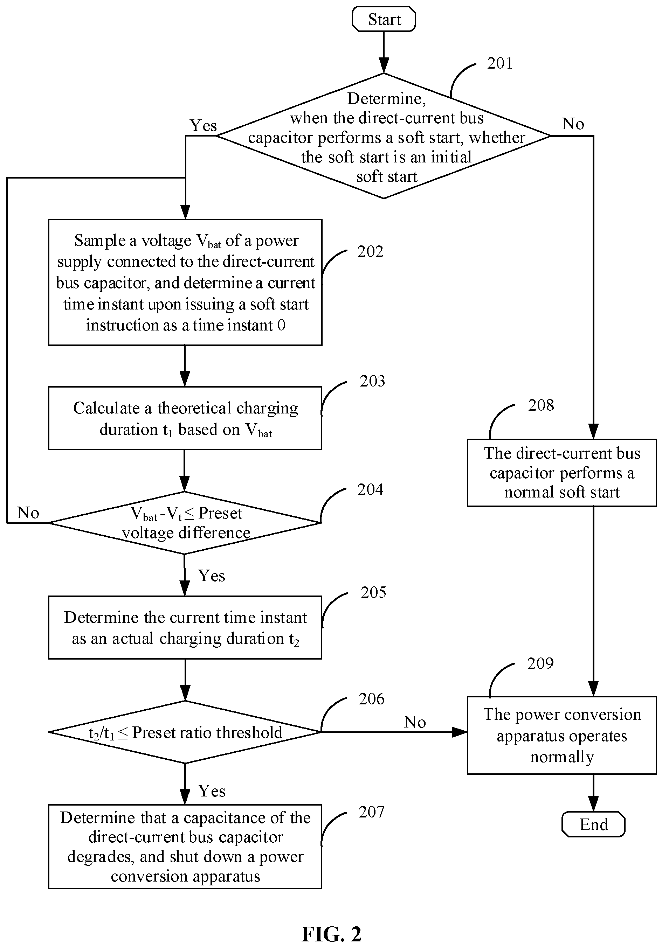

FIG. 2 is a schematic flowchart of a method for detecting a capacitance of a direct-current bus capacitor according to another embodiment of the present disclosure, which is applied to a power conversion apparatus. As shown in FIG. 2, the method includes the following steps 201 to 209.

In step 201, when the direct-current bus capacitor performs a soft start, whether the soft start is an initial soft start is determined. Step 202 is performed if the soft start is the initial soft start; and step 208 is performed if the soft start is not the initial soft start.

In step 202, a voltage $V_{bat}$ of the power supply connected to the direct-current bus capacitor is sampled, and a current time instant upon issuing a soft start instruction is determined as a time instant 0.

In step 203, a duration $t_1$ (that is, the theoretical charging duration) actually taken for the direct-current bus capacitor to perform the initial soft start is calculated based on the voltage $V_{bat}$ of the power supply connected to the direct-current bus capacitor.

Those skilled in the art can understand that step 203 is performed once at any time after step 202 and before step 206.

In step 204, whether a difference between the voltage $V_{bat}$ of the power supply connected to the direct-current bus capacitor and a voltage Vt of the direct-current bus capacitor at a current time instant is less than or equal to a preset voltage difference is determined; step 205 is performed if the difference is less than or equal to the preset voltage difference; and step 202 is performed if the difference is greater than the preset voltage difference.

Following the above example, the preset voltage difference may be 30V.

In step 205, the current time instant is recorded as a duration $t_2$ theoretically (that is, the actual charging duration) taken for the direct-current bus capacitor to perform the initial soft start.

In step 206, whether a ratio of the actual charging duration $t_2$ to the theoretical charging duration $t_1$ is less than or equal to a preset ratio threshold is determined; step 207 is performed if the ratio is less than or equal to the preset ratio threshold; and step 209 is performed if the ratio is greater than the preset ratio threshold.

In step 207, it is determined that the capacitance of the direct-current bus capacitor degrades, and the power conversion apparatus is shut down.

In step 208, the direct-current bus capacitor performs a normal soft start.

In step 209, the power conversion apparatus operates normally.

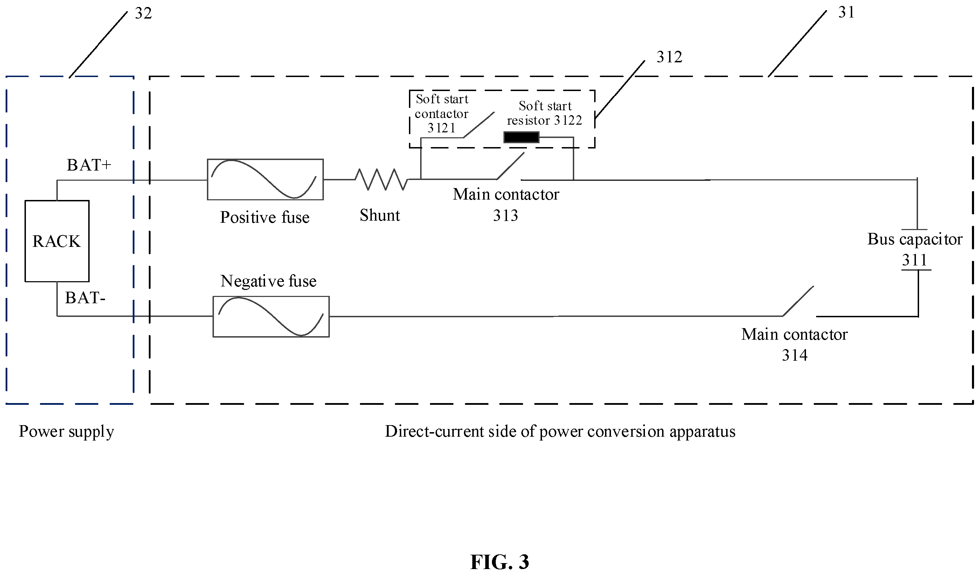

Based on a general inventive concept, a power conversion apparatus is further provided according to the present disclosure. FIG. 3 is a schematic structural diagram of a power conversion apparatus according to an embodiment of the present disclosure. Referring to FIG. 3, the power conversion apparatus includes a main circuit 31 and a controller. The controller is not shown in FIG. 3.

In the main circuit 31, a direct-current bus capacitor 311 is connected between a positive electrode and a negative electrode of a direct-current bus.

The controller is configured to detect a capacitance of the direct-current bus capacitor 311 by using the method described above.

In an embodiment of the present disclosure, the main circuit 31 includes a soft start unit 312 and a power conversion circuit.

The power conversion circuit is arranged at a rear stage of the direct-current bus capacitor 311, that is, on a right side of 311 as shown in FIG. 3. A direct-current side of the power conversion circuit is connected to the direct-current bus.

The soft start unit 312 is connected in parallel with a main contactor 313 between the direct-current bus and a power supply.

In an embodiment of the present disclosure, the power conversion circuit includes a DC/AC conversion circuit. When the DC/AC conversion circuit is a bidirectional DC/AC conversion circuit and the power supply 32 is an energy storage battery (such as RACK shown in FIG. 3), the power conversion apparatus is a PCS.

In an embodiment of the present disclosure, the soft start unit 312 includes a soft start contactor 3121 and a soft start resistor 3122.

The soft start contactor 3121 is connected in series with the soft start resistor 3122.

The above method embodiments are described as combinations of a series of actions for the sake of brevity. However, those skilled in the art should understand that the present disclosure is not limited to the described order of the actions. Instead, some of the steps may be performed in a different order or simultaneously according to the present disclosure.

In addition, those skilled in the art should also understand that the embodiments described in the specification are preferred embodiments, and the actions and modules described are unnecessary for the present disclosure.

It should be noted that all the embodiments in this specification are described in a progressive way, and each embodiment focuses on the differences from other embodiments. The same and similar parts among the embodiments can be referred to each other. Since apparatus embodiments are similar to method embodiments, the description thereof is relatively simple, and reference may be made to the description of the method embodiments for relevant parts.

Steps in the embodiments of the present disclosure can be performed in a different order, merged, and deleted. Technical features disclosed in the embodiments can be replaced or combined.

Finally, it should also be noted that in the present disclosure, relational terms such as first and second are only used to distinguish one entity or operation from another, and do not necessarily require or imply that any such actual relationship or order exists in these entities or operations. Furthermore, the term "comprise", "include" or any other variation thereof is intended to cover a non-exclusive inclusion, so that a process, a method, an article, or a device including a set of elements includes not only those elements, but also other elements not expressly listed or elements inherent in such a process, method, article, or device. Unless expressively limited, the statement "including a..." does not exclude the case that other similar elements may exist in the process, method, article or device including the elements.

On a basis of the disclosed embodiments, the features in different embodiments of the specification may be mutually replaced or combined, so that those skilled in the art can implement or utilize the present disclosure. Various modifications to these embodiments are apparent to those skilled in the art, and the general principles defined herein may be implemented in other embodiments without departing from the spirit or scope of the present disclosure. Therefore, the present disclosure is not to be limited to the embodiments shown herein, but is conformed to the widest scope consistent with the principles and novel features disclosed herein.

**Claims**

1.  A method for detecting a capacitance of a direct-current bus capacitor, **characterized by** comprising:

    obtaining an actual charging-discharging duration of the direct-current bus capacitor of a power conversion apparatus, wherein the actual charging-discharging duration starts from a time instant when a direct-current side of the power conversion apparatus is connected to a power supply, and a voltage of the direct-current bus capacitor upon completion of charging the direct-current bus capacitor is less than a voltage of the power supply in response to the actual charging-discharging duration being an actual charging duration;
comparing the actual charging-discharging duration with a preset charging-discharging duration to obtain a comparison result; and
determining, based on the comparison result, whether the capacitance of the direct-current bus capacitor degrades.

2.  The method for detecting a capacitance of a direct-current bus capacitor according to claim 1, wherein the comparison result is a ratio of the actual charging-discharging duration to the preset charging-discharging duration, and
wherein the determining, based on the comparison result, whether the capacitance of the direct-current bus capacitor degrades comprises:

    determining whether the ratio is less than a preset ratio threshold; and
    determining, in response to the ratio being less than the preset ratio threshold, that the capacitance of the direct-current bus capacitor degrades.

3.  The method for detecting a capacitance of a direct-current bus capacitor according to claim 1, wherein the obtaining the actual charging-discharging duration of the direct-current bus capacitor of the power conversion apparatus comprises:

    obtaining the actual charging duration of the direct-current bus capacitor in response to the direct-current bus capacitor being in a charging state, wherein the charging state refers to a charging state during an initial soft start within a preset cycle; or
    obtaining an actual discharging duration of the direct-current bus capacitor in response to the direct-current bus capacitor being in a discharging state.

4.  The method for detecting a capacitance of a direct-current bus capacitor according to any one of claims 1 to 3, wherein before comparing the actual charging-discharging duration with the preset charging-discharging duration, the method further comprises:
calculating the preset charging-discharging duration.

5.  The method for detecting a capacitance of a direct-current bus capacitor according to claim 4, wherein the calculating the preset charging-discharging duration comprises:
calculating the preset charging-discharging duration based on an initial voltage and a target voltage of the direct-current bus capacitor, the voltage of the power supply, an initial capacitance of the direct-current bus capacitor, and a resistance of a charging-discharging branch.

6. The method for detecting a capacitance of a direct-current bus capacitor according to claim 5, wherein in response to the actual charging-discharging duration being an actual charging duration of the direct-current bus capacitor in a charging state during an initial soft start within a preset cycle, the initial voltage is zero, and the resistance of the charging-discharging branch is a resistance of a soft start resistor between the power supply and the direct-current bus capacitor.

7. The method for detecting a capacitance of a direct-current bus capacitor according to claim 5, wherein the target voltage is equal to a difference between the voltage of the power supply and a preset voltage.

8. The method for detecting a capacitance of a direct-current bus capacitor according to any one of claims 1 to 3, wherein after determining, based on the comparison result, whether the capacitance of the direct-current bus capacitor degrades, the method further comprises:
controlling, in response to determining that the capacitance of the direct-current bus capacitor degrades, a device in which the direct-current bus capacitor is located to be shut down.

9. A power conversion apparatus, comprising:

   a main circuit; and
   a controller, wherein
   in the main circuit, a direct-current bus capacitor is connected between a positive electrode and a negative electrode of a direct-current bus; and
   the controller is configured to detect a capacitance of the direct-current bus capacitor by using the method according to any one of claims 1 to 8.

10. The power conversion apparatus according to claim 9, wherein the main circuit comprises a soft start unit and a power conversion circuit, wherein

    a direct-current side of the power conversion circuit is connected to the direct-current bus; and
    the soft start unit is connected in parallel with a main contactor between the direct-current bus and a power supply.

11. The power conversion apparatus according to claim 10, wherein the soft start unit comprises a soft start contactor and a soft start resistor, wherein
the soft start contactor is connected in series with the soft start resistor.

Obtain an actual charging-discharging duration of a direct-current bus
capacitor of a power conversion apparatus, where the actual charging-
discharging duration starts from a time instant when a direct-current side of
the power conversion apparatus is connected to a power supply — 101

Compare the actual charging-discharging duration with a preset charging-
discharging duration to obtain a comparison result — 102

Determine, based on the comparison result, whether a capacitance of the
direct-current bus capacitor degrades — 103

**FIG. 1**

FIG. 2

31

312

Soft start resistor 3122

Soft start contactor 3121

Main contactor 313

Shunt

Positive fuse

Negative fuse

Bus capacitor 311

Main contactor 314

Direct-current side of power conversion apparatus

32

BAT+

RACK

BAT-

Power supply

**FIG. 3**

## INTERNATIONAL SEARCH REPORT

| | International application No. |
|---|---|
| | **PCT/CN2024/083702** |

| **A.** | **CLASSIFICATION OF SUBJECT MATTER** |
|---|---|
| | G01R27/26(2006.01)i |

According to International Patent Classification (IPC) or to both national classification and IPC

| **B.** | **FIELDS SEARCHED** |
|---|---|

Minimum documentation searched (classification system followed by classification symbols)

IPC:G01R27

Documentation searched other than minimum documentation to the extent that such documents are included in the fields searched

Electronic data base consulted during the international search (name of data base and, where practicable, search terms used)

CNTXT, CNABS, CNKI, ENTXTC: 直流, 电容, 容值, 充电, 放电, 时长, 时间, 比较, 比值, 缓起, 缓启, 软启, DC, CAPACITOR, CHARGE, DISCHARGE, TIME, COMPARE, RATIO

| **C.** | **DOCUMENTS CONSIDERED TO BE RELEVANT** | |
|---|---|---|

| Category* | Citation of document, with indication, where appropriate, of the relevant passages | Relevant to claim No. |
|---|---|---|
| PX | CN 117269622 A (SUNGROW POWER SUPPLY CO., LTD.) 22 December 2023 (2023-12-22) claims 1-11 | 1-11 |
| X | KR 102464546 B1 (LSIS CO., LTD.) 07 November 2022 (2022-11-07) description, paragraphs 30-59, and figures 1-3 | 1-11 |
| X | US 2021099102 A1 (MITSUBISHI ELECTRIC CORP.) 01 April 2021 (2021-04-01) description, paragraphs 21-129, and figures 1-7 | 1-11 |
| X | CN 114935730 A (GUANDONG MIDEA HVAC EQUIPMENT CO., LTD. et al.) 23 August 2022 (2022-08-23) description, paragraphs 66-171, and figures 1-8 | 1-11 |
| X | KR 20210107415 A (LS ELECTRIC CO., LTD.) 01 September 2021 (2021-09-01) description, paragraphs 48-72, and figures 4-8 | 1-11 |
| A | CN 106058930 A (XUJI GROUP CO., LTD. et al.) 26 October 2016 (2016-10-26) entire document | 1-11 |

| ☑ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 May 2024** | **04 June 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 782 849 A1**

## INTERNATIONAL SEARCH REPORT

International application No.

**PCT/CN2024/083702**

### C.    DOCUMENTS CONSIDERED TO BE RELEVANT

| Category* | Citation of document, with indication, where appropriate, of the relevant passages | Relevant to claim No. |
|---|---|---|
| A | CN 109633283 A (XIAMEN KEHUA HENGSHENG CO., LTD. et al.) 16 April 2019 (2019-04-16) entire document | 1-11 |
| A | CN 112710901 A (SHENZHEN HOPEWIND ELECTRIC CORP., LTD.) 27 April 2021 (2021-04-27) entire document | 1-11 |
| A | JP 2021175252 A (FUJI ELECTRIC CO., LTD.) 01 November 2021 (2021-11-01) entire document | 1-11 |

Form PCT/ISA/210 (second sheet) (July 2022)

14

**INTERNATIONAL SEARCH REPORT**
Information on patent family members

International application No.

**PCT/CN2024/083702**

| Patent document cited in search report | | | Publication date (day/month/year) | Patent family member(s) | | | Publication date (day/month/year) |
|---|---|---|---|---|---|---|---|
| CN | 117269622 | A | 22 December 2023 | None | | | |
| KR | 102464546 | B1 | 07 November 2022 | KR | 20180074934 | A | 04 July 2018 |
| US | 2021099102 | A1 | 01 April 2021 | EP | 3633841 | A1 | 08 April 2020 |
| | | | | EP | 3633841 | A4 | 20 May 2020 |
| | | | | EP | 3633841 | B1 | 29 December 2021 |
| | | | | US | 11031882 | B2 | 08 June 2021 |
| | | | | JP | 6338791 | B1 | 06 June 2018 |
| | | | | JPWO | 2018216208 | A1 | 27 June 2019 |
| | | | | WO | 2018216208 | A1 | 29 November 2018 |
| CN | 114935730 | A | 23 August 2022 | None | | | |
| KR | 20210107415 | A | 01 September 2021 | None | | | |
| CN | 106058930 | A | 26 October 2016 | None | | | |
| CN | 109633283 | A | 16 April 2019 | None | | | |
| CN | 112710901 | A | 27 April 2021 | None | | | |
| JP | 2021175252 | A | 01 November 2021 | JP | 7452224 | B2 | 19 March 2024 |

Form PCT/ISA/210 (patent family annex) (July 2022)

**EP 4 782 849 A1**

**Patent documents cited in the description**

- CN 202311206614